# EUROPEAN PATENT APPLICATION

(11) **EP 2 998 824 A1**
(43) Date of publication of application: **23.03.2016**
(21) Application number: 13884527.6
(22) Date of filing: 16.05.2013
(51) Int. Cl.: G06F 1/18

(54) **SERVER SHELF FRAME**

(71) Applicant: Dongguan Denese Computer Co., Ltd., Dongguan, Guangdong 523000 (CN); Chen, Richard, Zhongshan, Guangdong 523000 (CN)
(72) Inventor: CHEN, Richard, Dongguan Guangdong 523000 (CN)
(74) Representative: Meyer, Thorsten
(86) International application number: PCT/CN2013/075712
(87) International publication number: WO 2014/183290

(57) **Abstract**

A server frame includes a motherboard subframe (1), a radiator subframe (2), and a storage subframe (3), the motherboard subframe (1) is connected to the storage subframe (3) by using the radiator subframe (2), wherein the motherboard subframe (1), the radiator subframe (2), and the storage subframe (3) are connected together in a detachable manner. The server frame has the advantages: the disassembly and assembly are convenient, the packaging size is saved, and the transportation cost is reduced.

## Description

### FIELD OF THE INVENTION

The present invention relates to a server frame.

### BACKGROUND OF THE INVENTION

Servers are high-performance computers in a network environment, which monitor service requests submitted by other computers (clients) on the network and provide corresponding services. Therefore, the server must have the ability to provide services and assure quality thereof. The server whose composition is similar to a computer includes a processor, a hard drive, a storage, a system bus, etc, and is particularly customized for specific network applications, and therefore the server greatly differs from the computer in processing capacity, stability, reliability, security, scalability, manageability and other aspects. A computer software for managing resources and providing services to users is usually divided into file servers (allows users to access files on other computers), database servers, and application servers.

The server is so important, self-evidently, shelf frame for protecting and assembling the server is also quite important. A conventional server frame for assembling a server includes a motherboard subframe, a radiator subframe, and a storage subframe, they are formed in an integrated frame, and the hard drive, the fan, the processor, the motherboard, and other components of the server are accordingly placed therein. The server will inevitably malfunction or be damaged after long-time use, and needs to be replaced in whole or transported to the factory for repair in whole, and the latter is more cumbersome. In addition, the production and sale of the shelf frame and the components are separate, that is, the shelf frame is often produced and sold by individual vendors and then equipped with the components therein by the user, therefore the integrated shelf frame may waste a lot of packing space during package and transportation, and thereby greatly increase the transportation cost.

### SUMMARY OF THE INVENTION

One objective of the present invention is to provide a server frame, which has the advantages of convenient assembling and disassembling, small packaging size, and low transportation costs.

To achieve the above objective, a server frame is provided, which includes a motherboard subframe, a radiator subframe, and a storage subframe, the motherboard subframe is connected to the storage subframe by using the radiator subframe, wherein the motherboard subframe, the radiator subframe, and the storage subframe are connected together in a detachable manner.

In this solution, the motherboard subframe, the radiator subframe, and the storage subframe of the present invention are connected together in a detachable manner, and thereby can be assembled and disassembled conveniently. The components of the server will inevitably malfunction or be damaged after long-time use, if replacement or repair is needed, only the corresponding unit damaged needs to be disassembled without being replaced in whole or being transported to the factory for repairing in whole, which facilitates the users. In addition, the frame can be disassembled into three parts, thereby can be stacked flexibly during package and transportation without packing the server in whole as the prior art. The server greatly saves the packaging size and reduces the transportation costs.

Concretely, the motherboard subframe, the radiator subframe, and the storage subframe are connected together by using bolts, screws, rivets, or snaps in a detachable manner.

Preferably, each of connection positions of the motherboard subframe, the radiator subframe, and the storage subframe has a flange structure configured thereon, and the motherboard subframe, the radiator subframe, and the storage subframe are connected together by connecting the flange structures with bolts, screws, rivets, or snaps in a detachable manner.

Concretely, the motherboard subframe includes a first bottom plate, a first left side plate and a first right side plate respectively configured at left and right sides of the first bottom plate, and a radiator plate configured at a rear side of the first bottom plate, a first opening is formed by leading edges of the first bottom plate, the first left side plate, and the first right side plate, and the first opening is connected to the radiator subframe in a detachable manner.

To further facilitate the packaging and reduce the packaging size, the radiator plate is connected to the first bottom plate in a detachable manner, and the first left side plate and the first right side plate are connected to the first bottom plate in a detachable or foldable manner.

Concretely, the radiator subframe includes a second bottom plate, and a second left side plate and a second right side plate respectively configured at left and right sides of the second bottom plate, a second opening is formed by leading edges of the second bottom plate, the second left side plate, and the second right side plate, a third opening is formed by trailing edges of the second bottom plate, the second left side plate, and the second right side plate, the second opening is connected to the storage subframe in a detachable manner, and the third opening is connected to the motherboard subframe in a detachable manner.

Preferably, to take full advantage of stackable space, a width (W1) of the first bottom plate is equal to a length (L1) of the storage subframe, and a length (L2) of the first bottom plate is equal to or slightly larger than the sum of a width (W2) of the storage subframe and a width (W3) of the second bottom plate.

Preferably, the storage subframe includes plurality sets of storage shells lengthwise arranged, each set of the storage shell includes a plurality of storage cells and has a separable structure.

In this solution, each set of the storage shell of the present invention has a separable structure, if the hard drive malfunctions or is damaged, just a set of the storage shell thereof needs to be removed out, and then a new set of storage shell is reinstalled to the original position so as to complete replacement, which greatly reduces the replacement and maintenance time. Of course, if the hard drive capacity is full, a set of the storage shell thereof can be removed and replaced for updating. Alternatively, you can add a new set of the storage shell, which greatly facilitates the upgrading of products.

Preferably, plurality sets of the storage shells lengthwise arranged are connected together by using bolts, screws, rivets, or snaps in a detachable manner. Each set of the storage shell includes four the storage cells.

Preferably, each set of the storage shell includes two storage subshells connected in a detachable manner, and each of the storage subshells includes two the storage cells. The storage subshells are connected together by using bolts, screws, rivets, or snaps in a detachable manner.

Preferably, each set of the storage shell includes a upper panel, a lower panel, and a plurality of spacer plates configured between the upper panel and the lower panel, space between the upper panel and the lower panel is partitioned into a plurality of the storage cells by the spacer plates, and a left side plate and a right side plate are respectively configured at left and right sides of the upper panel and the lower panel.

Preferably, an engaging structure is configured at rear ends of the left side plate and the right side plate. A ventilation structure configured at rear side of the storage shell includes a holder, a panel configured in the holder, and a support bar configured between the holder and the panel.

In comparison with the prior art, the motherboard subframe, the radiator subframe, and the storage subframe of the present invention can be assembled and disassembled conveniently, if replacement or repair is needed, only the corresponding unit damaged needs to be disassembled without being replaced in whole or being transported to the factory for repairing in whole, which facilitates the users. In addition, they can be stacked flexibly during package and transportation, which greatly saves the packaging size and reduces the transportation costs.

### BRIEF DESCRIPTION OF THE DRAWINGS

The accompanying drawings facilitate an understanding of the various embodiments of this invention. In such drawings:
Fig. 1 is an exploded view of a server frame of the present invention;
Fig. 2 is a perspective view of a server frame of the present invention;
Fig. 3 is another exploded view of a server frame of the present invention;
Fig. 4 is a perspective view of a flange structure of a server frame of the present invention;
Fig. 5 is a perspective view of an assembly of a radiator subframe and a storage subframe of the present invention;
Fig. 6 is a perspective view of a 1U storage subframe;
Fig. 7 is a perspective view of a 4U storage subframe;
Fig. 8 is a perspective view of a storage subshell; and

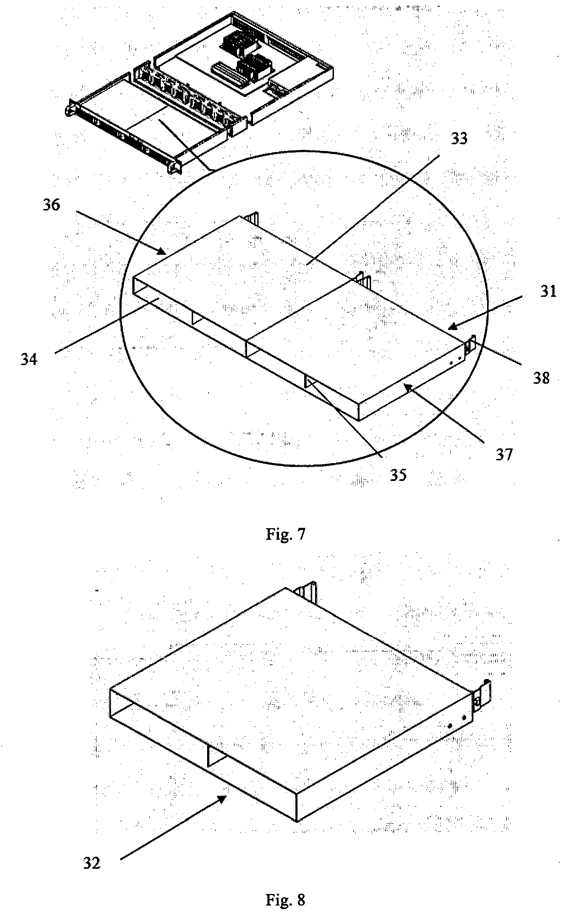

Fig. 8 is a perspective view of a storage subframe seen from the rear.

### DETAILED DESCRIPTION OF ILLUSTRATED EMBODIMENTS

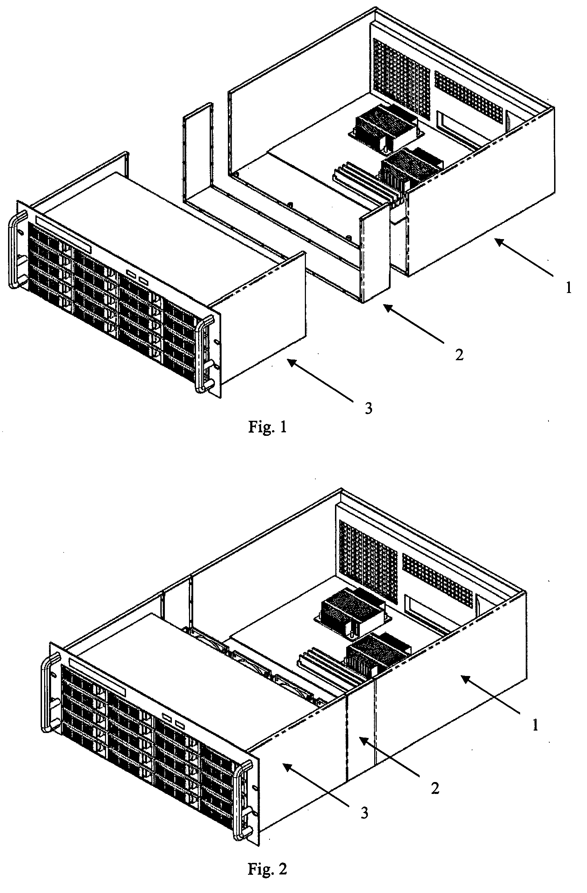

As illustrated in Figs. 1-3, a server frame of the present invention includes a motherboard subframe 1, a radiator subframe 2, and a storage subframe 3, the motherboard subframe 1 is connected to the storage subframe 3 by using the radiator subframe 2, wherein the motherboard subframe 1, the radiator subframe 2, and the storage subframe 3 are connected together in a detachable manner. Wherein the motherboard subframe 1 is adapted for installing a processor, a motherboard and other components is the control component of the server; the radiator subframe 2 adapted for installing fans and other radiator components is used for cooling the server; the storage subframe 3 adapted for installing a hard drive is used to store data of the network.

The motherboard subframe 1, the radiator subframe 2, and the storage subframe 3 of the present invention are connected together in a detachable manner, and thereby can be assembled and disassembled conveniently. The components of the server will inevitably malfunction or be damaged after long-time use, if replacement or repair is needed, only the corresponding unit damaged needs to be disassembled without being replaced in whole or being transported to the factory for repairing in whole, which facilitates the users. In addition, the frame can be disassembled into three parts, thereby can be stacked flexibly during package and transportation without packing the server in whole as the prior art. The server greatly saves the packaging size and reduces the transportation costs.

Concretely, the motherboard subframe 1, the radiator subframe 2, and the storage subframe 3 are connected together by using bolts, screws, rivets, or snaps in a detachable manner.

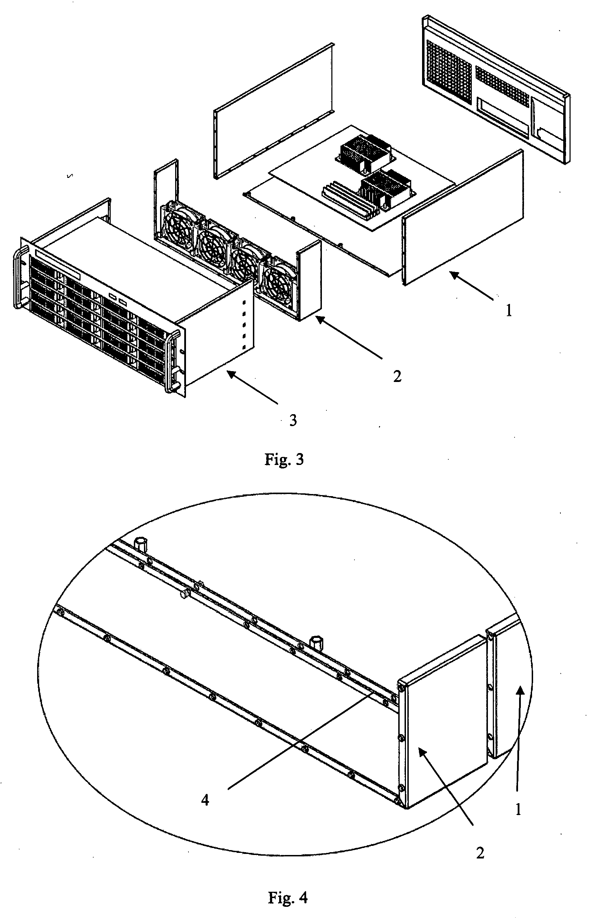

Further, as shown in Fig. 4, each of connection positions of the motherboard subframe 1, the radiator subframe 2, and the storage subframe 3 has a flange structure 4 configured thereon, and the motherboard subframe 1, the radiator subframe 2, and the storage subframe 3 are connected together by connecting the flange structures 4 with bolts, screws, rivets, or snaps in a detachable manner.

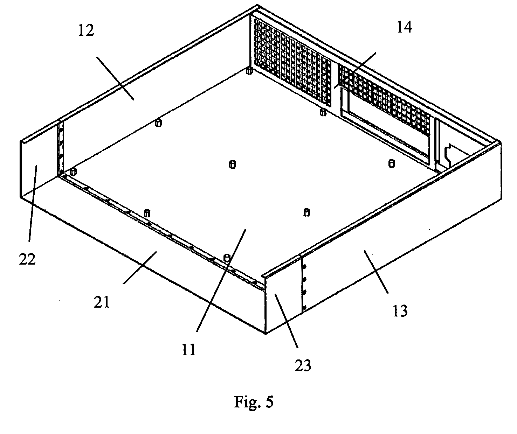

Concretely, as shown in Fig. 5, the motherboard subframe 1 includes a first bottom plate 11, a first left side plate 12 and a first right side plate 13 respectively configured at left and right sides of the first bottom plate 11, and a radiator plate 14 configured at a rear side of the first bottom plate 11, a first opening is formed by leading edges of the first bottom plate 11, the first left side plate 12, and the first right side plate 13, and the first opening is connected to the radiator subframe 2 in a detachable manner.

To further facilitate the packaging and reduce the packaging size, the radiator plate 14 is connected to the first bottom plate 11 in a detachable manner, and the first left side plate 12 and the first right side plate 13 are connected to the first bottom plate 11 in a detachable or foldable manner.

Concretely, the radiator subframe 2 includes a second bottom plate 21, and a second left side plate 22 and a second right side plate 23 respectively configured at left and right sides of the second bottom plate 21, a second opening is formed by leading edges of the second bottom plate 21, the second left side plate 22, and the second right side plate 23, a third opening is formed by trailing edges of the second bottom plate 21, the second left side plate 22, and the second right side plate 23, the second opening is connected to the storage subframe 3 in a detachable manner, and the third opening is connected to the motherboard subframe 1 in a detachable manner.

The server frame is firstly equipped with the hard drive, the fan, and the control components, secondly equipped with a top cover and a surface cover, and then the server frame is put into a cabinet, by this time the up, down, left, and right sides of the server frame are all blocked, so only the front and rear sides thereof have space for radiator, which is just used by the fans to radiate. Meanwhile, the server frame is made of metal, which also can help to improve the radiating.

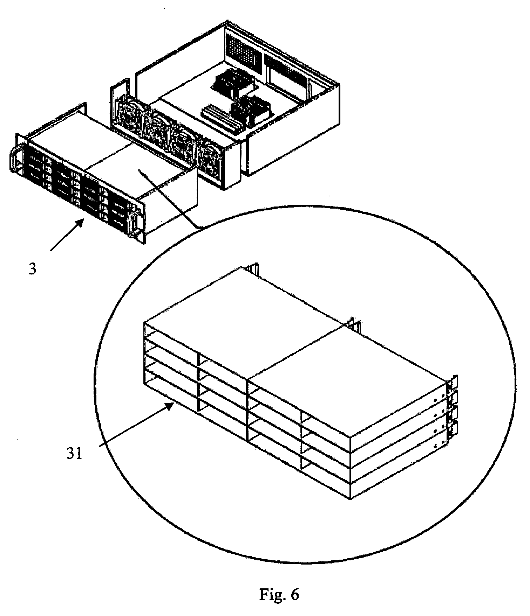

Further, as shown in Fig. 6, the storage subframe 6 includes plurality sets of storage shells lengthwise arranged, each set of the storage shell includes a plurality of storage cells and has a separable structure.

Further, to take full advantage of stackable space, a width W1 of the first bottom plate 11 is equal to a length L1 of the storage subframe 3, and a length L2 of the first bottom plate 11 is equal to or slightly larger than the sum of a width W2 of the storage subframe 3 and a width W3 of the second bottom plate 21.

Each set of the storage shell of the present invention has a separable structure, if the hard drive malfunctions or is damaged, just a set of the storage shell thereof needs to be removed out, and then a new set of storage shell is reinstalled to the original position so as to complete replacement, which greatly reduces the replacement and maintenance time. Of course, if the hard drive capacity is full, a set of the storage shell thereof can be removed and replaced for updating. Alternatively, you can add a new set of the storage shell, which greatly facilitates the upgrading of products.

The height of the server shelf is grouped into 1U-4U according to a specification whose unit is U (Unit), wherein 1U is 44.5mm, that is, the height of a set of storage shell is 1U. The user can flexibly assemble the storage shells provided by manufacturers according to their own actual needs, which is easy to use.

As shown in Fig. 7, plurality sets of the storage shells 31 lengthwise arranged are connected together by using bolts, screws, rivets, or snaps in a detachable manner. Each set of the storage shell 31 includes four storage cells.

As shown in Figs. 7 and 8, each set of the storage shell 31 includes two storage subshells 32 connected in a detachable manner, and each of the storage subshells 32 includes two storage cells. The storage subshells 32 are connected together by using bolts, screws, rivets, or snaps in a detachable manner.

As shown in Fig. 7, each set of the storage shell 31 includes a upper panel 33, a lower panel 34, and a plurality of spacer plates 35 configured between the upper panel 33 and the lower panel 34, space between the upper panel 33 and the lower panel 34 is partitioned into a plurality of the storage cells by the spacer plates 35, and a left side plate 36 and a right side plate 37 are respectively configured at left and right sides of the upper panel 33 and the lower panel 34.

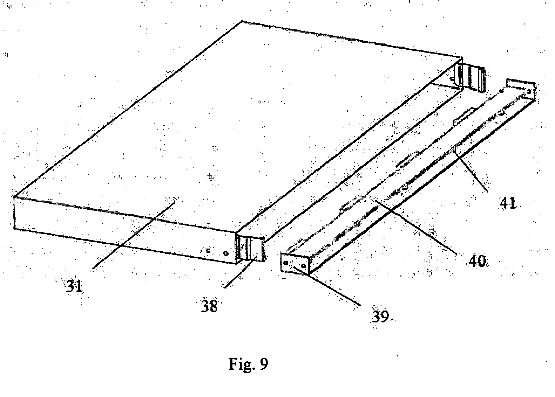

As shown in Fig. 9, an engaging structure 38 is configured at rear ends of the left side plate 36 and the right side plate 37. A ventilation structure configured at rear side of the storage shell 31 includes a holder 39, a panel 40 configured in the holder 39, and a support bar 41 configured between the holder 39 and the panel 40.

While the invention has been described in connection with what are presently considered to be the most practical and preferred embodiments, it is to be understood that the invention is not to be limited to the disclosed embodiments, but on the contrary, is intended to cover various modifications and equivalent arrangements included within the spirit and scope of the invention.

## Claims

1. A server frame, comprising a motherboard subframe, a radiator subframe, and a storage subframe, said motherboard subframe is connected to said storage subframe by using said radiator subframe, wherein said motherboard subframe, said radiator subframe, and said storage subframe are connected together in a detachable manner.

2. The server frame according to claim 1, wherein said motherboard subframe, said radiator subframe, and said storage subframe are connected together by using bolts, screws, rivets, or snaps in a detachable manner.

3. The server frame according to claim 2, wherein each of connection positions of said motherboard subframe, said radiator subframe, and said storage subframe has a flange structure configured thereon, and said motherboard subframe, said radiator subframe, and said storage subframe are connected together by connecting said flange structures with bolts, screws, rivets, or snaps in a detachable manner.

4. The server frame according to claim 1, wherein said motherboard subframe comprises a first bottom plate, a first left side plate and a first right side plate respectively configured at left and right sides of said first bottom plate, and a radiator plate configured at a rear side of said first bottom plate, a first opening is formed by leading edges of said first bottom plate, said first left side plate, and said first right side plate, and said first opening is connected to said radiator subframe in a detachable manner.

5. The server frame according to claim 4, wherein said radiator plate is connected to said first bottom plate in a detachable manner.

6. The server frame according to claim 5, wherein said first left side plate and said first right side plate are connected to said first bottom plate in a detachable or foldable manner.

7. The server frame according to claim 4, wherein said radiator subframe comprises a second bottom plate, and a second left side plate and a second right side plate respectively configured at left and right sides of said second bottom plate, a second opening is formed by leading edges of said second bottom plate, said second left side plate, and said second right side plate, a third opening is formed by trailing edges of said second bottom plate, said second left side plate, and said second right side plate, said second opening is connected to said storage subframe in a detachable manner, and said third opening is connected to said motherboard subframe in a detachable manner.

8. The server frame according to claim 7, wherein a width (W1) of said first bottom plate is equal to a length (L1) of said storage subframe, and a length (L2) of said first bottom plate is equal to or slightly larger than the sum of a width (W2) of said storage subframe and a width (W3) of said second bottom plate.

9. The server frame according to claim 1, wherein said storage subframe comprises plurality sets of storage shells lengthwise arranged, and each set of said storage shell comprises a plurality of storage cells and has a separable structure.

10. The server frame according to claim 9, wherein plurality sets of said storage shells lengthwise arranged are connected together by using bolts, screws, rivets, or snaps in a detachable manner.

11. The server frame according to claim 9, wherein each set of said storage shell comprises four said storage cells.

12. The server frame according to claim 9, wherein each set of said storage shell comprises two storage subshells connected in a detachable manner, and each of said storage subshells comprises two said storage cells.

13. The server frame according to claim 12, wherein said storage subshells are connected together by using bolts, screws, rivets, or snaps in a detachable manner.

14. The server frame according to claim 9, wherein each set of said storage shell comprises a upper panel, a lower panel, and a plurality of spacer plates configured between said upper panel and said lower panel, space between said upper panel and said lower panel is partitioned into a plurality of said storage cells by said spacer plates, and a left side plate and a right side plate are respectively configured at left and right sides of said upper panel and said lower panel.

15. The server frame according to claim 14, wherein an engaging structure is configured at rear ends of said left side plate and said right side plate.

16. The server frame according to claim 9, wherein a ventilation structure configured at rear side of said storage shell comprises a holder, a panel configured in said holder, and a support bar configured between said holder and said panel.

17. The server frame according to any one of claims 1∼16, wherein said server frame is made of metal.
